(19) Europäisches Patentamt
European Patent Office
Office européen des brevets

(11) **EP 4 783 225 A1**

(12) **EUROPEAN PATENT APPLICATION**
published in accordance with Art. 153(4) EPC

(43) Date of publication:
**29.07.2026 Bulletin 2026/31**

(21) Application number: **24871907.2**

(22) Date of filing: **13.09.2024**

(51) International Patent Classification (IPC):
*H01L 21/02* (2006.01)     *H01L 21/68* (2006.01)
*H01L 21/683* (2006.01)

(52) Cooperative Patent Classification (CPC):
**H10P 72/50; H10P 72/70; H10P 95/00**

(86) International application number:
**PCT/JP2024/032829**

(87) International publication number:
**WO 2025/070112 (03.04.2025 Gazette 2025/14)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **26.09.2023 JP 2023163942**

(71) Applicant: **Tokyo Electron Limited
Tokyo 107-6325 (JP)**

(72) Inventor: **SHINOZUKA, Shinichi
Koshi City, Kumamoto 861-1116 (JP)**

(74) Representative: **Manitz Finsterwald
Patent- und Rechtsanwaltspartnerschaft mbB
Martin-Greif-Straße 1
80336 München (DE)**

(54) **SUBSTRATE PROCESSING SYSTEM, JOINING DEVICE, AND JOINING METHOD**

(57)     A substrate processing system includes a bonding apparatus bonding substrates together; and control circuitry. The bonding apparatus includes: a first holder holding a first substrate; a second holder disposed below or above the first holder, and holding a second substrate; a contact member bringing a center of the first substrate and a center of the second substrate into contact with each other; an imaging device imaging at least the first substrate; and a moving mechanism moving the first holder, the second holder, and the imaging device relative to one another. The first substrate has at least one reference point, coordinates of which are known with the center of the first substrate as an origin. The control circuitry executes a control including: (a) a process of imaging the first substrate to determine a virtual center of the first substrate; (b) a process of moving an imaging center of the imaging device from the virtual center to a position corresponding to the coordinates of the reference point when the virtual center is set as an origin; (c) a process of imaging the first substrate at the position to which the imaging center has been moved in the process (b) to obtain a coordinate difference between the imaging center and the reference point; (d) a process of correcting the virtual center to obtain the center of the first substrate; and (e) a process of bringing the center of the first substrate obtained in the process (d) into contact with the center of the second substrate.

*FIG. 11*

## Description

### TECHNICAL FIELD

The present disclosure relates to a substrate processing system, a bonding apparatus, and a bonding system.

### BACKGROUND

Patent Document 1 discloses a bonding apparatus for bonding wafers to each other. This bonding apparatus has an upper chuck configured to vacuum-suction an upper wafer to attract and hold the upper wafer on its bottom surface, and a lower chuck provided below the upper chuck and configured to vacuum-suction a lower wafer to attract and hold the lower wafer on its top surface. The two wafers are bonded together while vertically arranged to face each other.

### PRIOR ART DOCUMENT

Patent Document 1: Japanese Patent Laid-open Publication No. 2015-095579

### DISCLOSURE OF THE INVENTION

### PROBLEMS TO BE SOLVED BY THE INVENTION

Exemplary embodiments provide a technique capable of appropriately bonding substrates together.

### MEANS FOR SOLVING THE PROBLEMS

In an exemplary embodiment, a substrate processing system includes a bonding apparatus bonding substrates together; and control circuitry. The bonding apparatus includes: a first holder holding a first substrate; a second holder disposed below or above the first holder, and holding a second substrate; a contact member bringing a center of the first substrate and a center of the second substrate into contact with each other; an imaging device imaging at least the first substrate; and a moving mechanism moving the first holder, the second holder, and the imaging device relative to one another. The first substrate has at least one reference point, coordinates of which are known with the center of the first substrate as an origin. The control circuitry executes a control including: (a) a process of imaging the first substrate to determine a virtual center of the first substrate; (b) a process of moving an imaging center of the imaging device from the virtual center to a position corresponding to the coordinates of the reference point when the virtual center is set as an origin; (c) a process of imaging the first substrate at the position to which the imaging center has been moved in the process (b) to obtain a coordinate difference between the imaging center and the reference point; (d) a process of correcting the virtual center to obtain the center of the first substrate; and (e) a process of bringing the center of the first substrate obtained in the process (d) into contact with the center of the second substrate.

### EFFECT OF THE INVENTION

According to the exemplary embodiment, it is possible to appropriately bond the substrates together.

### BRIEF DESCRIPTION OF THE DRAWINGS

FIG. 1 is a plan view illustrating a schematic configuration of a bonding system according to an exemplary embodiment.
FIG. 2 is a side view schematically illustrating an internal configuration of the bonding system according to the present exemplary embodiment.
FIG. 3 is a side view schematically illustrating a structure of a device wafer and a support wafer.
FIG. 4 is a plan view schematically illustrating the structure of the device wafer.
FIG. 5 is a plan view schematically illustrating the structure of the support wafer.
FIG. 6 is a transversal sectional view illustrating a schematic configuration of a bonding apparatus.

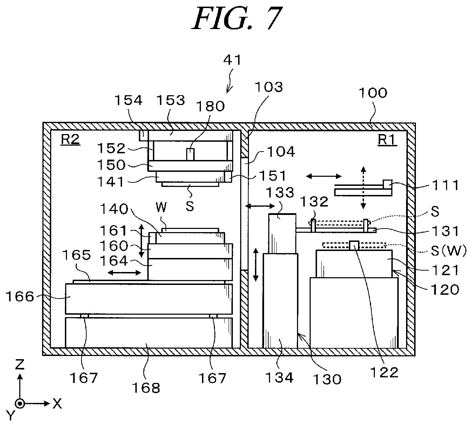

FIG. 7 is a longitudinal sectional view illustrating a schematic configuration of the bonding apparatus.

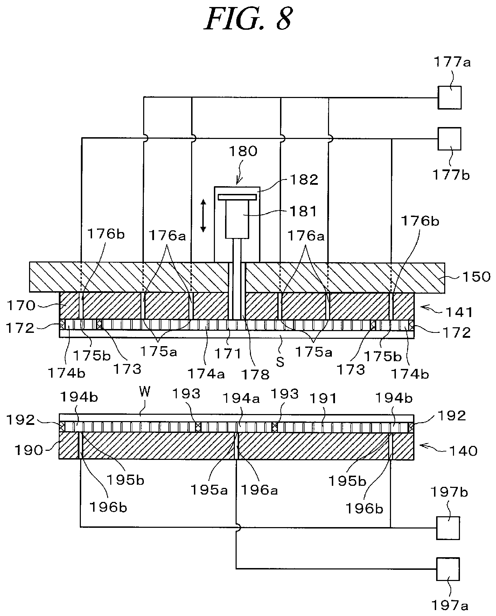

FIG. 8 is a longitudinal sectional view illustrating a schematic configuration of an upper chuck and a lower chuck.
FIG. 9 is a flowchart showing main processes of a bonding method.

FIG. 10 is a flowchart showing main processes of a first sub-process.

FIG. 11 is an explanatory diagram schematically illustrating first imaging data in the first sub-process.

FIG. 12 is an explanatory diagram schematically illustrating movement, coordinate differences, and correction in the first sub-process.

FIG. 13 is an explanatory diagram schematically illustrating second imaging data in the first sub-process.

FIG. 14 is an explanatory diagram schematically illustrating the second imaging data in the first sub-process.

FIG. 15 is a flowchart showing main processes of a second sub-process.

FIG. 16 is an explanatory diagram schematically illustrating third imaging data in the second sub-process.

FIG. 17A to FIG. 17H are explanatory diagrams illustrating respective states in the main processes of the second sub-process in a chronological order.

FIG. 18 is an explanatory diagram schematically illustrating movement, coordinate differences, and correction in the second sub-process.

FIG. 19 is an explanatory diagram schematically illustrating movement, coordinate differences, and correction in the second sub-process.

FIG. 20A to FIG. 20F are explanatory diagrams illustrating main processes of a bonding method.

FIG. 21 is a side view illustrating a schematic configuration of an inspection apparatus.

FIG. 22 is a flowchart showing main processes of an inspection method.

FIG. 23 is an explanatory diagram schematically illustrating an example of infrared imaging data in the inspection method.

FIG. 24 is an explanatory diagram schematically illustrating another example of infrared imaging data in the inspection method.

## DETAILED DESCRIPTION

In 3D integration technology, which stacks semiconductor devices in three dimensions, two sheets of semiconductor wafers (hereinafter simply referred to as "wafers") are bonded to each other. In the bonding process, the wafers are bonded together by a van der Waals force and hydrogen bonding (intermolecular force).

In the bonding apparatus disclosed in Patent Document 1, first, a central portion of the upper wafer, which is attracted to and held by the upper chuck, is pressed by a pressing member to be lowered into contact with a central portion of the lower wafer which is attracted to and held by the lower chuck. Then, bonding by the aforementioned intermolecular force begins between the pressed centers of the upper and lower wafers. Next, the vacuum-suctioning of the upper wafer is stopped from the central portion of the upper wafer toward its periphery, so the upper wafer is sequentially dropped onto and brought into contact with the lower wafer, gradually expanding the bonding between surfaces of the upper and lower wafers by the aforementioned intermolecular force. In this way, the entire surfaces of the upper wafer and the lower wafer are brought into contact with each other, so that the upper and lower wafers are bonded.

However, the bonding apparatus disclosed in Patent Document 1 does not consider appropriately determining the central portions of the upper and lower wafers, which serve as contact references. Furthermore, it does not consider inspecting the bonding state of the wafers, either.

Here, to properly bond the wafers, it is considered to, prior to bringing them into contact with each other, obtain images of the upper and lower wafers by using an imaging device and determine their central portions through image analysis using a commonly known algorithm. However, depending on the state of the upper or lower wafer, such as the state of an edge or a notch thereof, the central portions may not be appropriately determined through the image analysis using the known algorithm. Therefore, there is room for improvement in the conventional bonding processing for the wafers.

The present disclosure provides a technique capable of appropriately bonding substrates. Hereinafter, a substrate processing system, a bonding apparatus, a bonding method, and an inspection method according to an exemplary embodiment will be described with reference to the accompanying drawings. In addition, in the present specification and the drawings, parts having substantially the same functions and configurations will be assigned same reference numerals, and redundant descriptions thereof will be omitted.

<Configuration of substrate processing system>

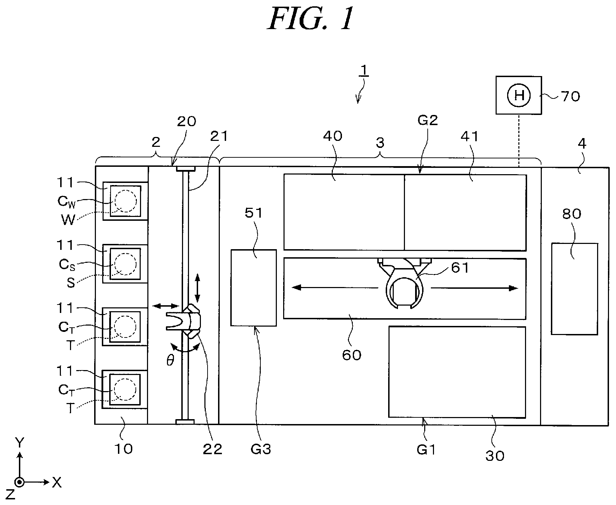

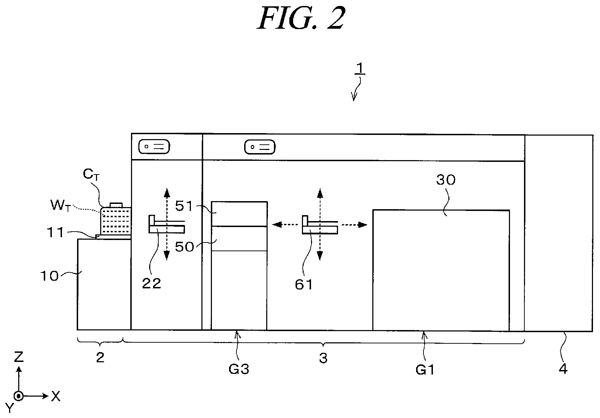

First, a configuration of a substrate processing system according to the present exemplary embodiment will be described. FIG. 1 is a plan view schematically illustrating a configuration of a substrate processing system 1. FIG. 2 is a side view schematically illustrating an internal configuration of the substrate processing system 1. Further, in the following, in order to clarify positional relationships, the X-axis, the Y-axis and the Z-axis directions, which are orthogonal to each other, will be defined, and the positive Z-axis direction will be regarded as a vertically upward direction.

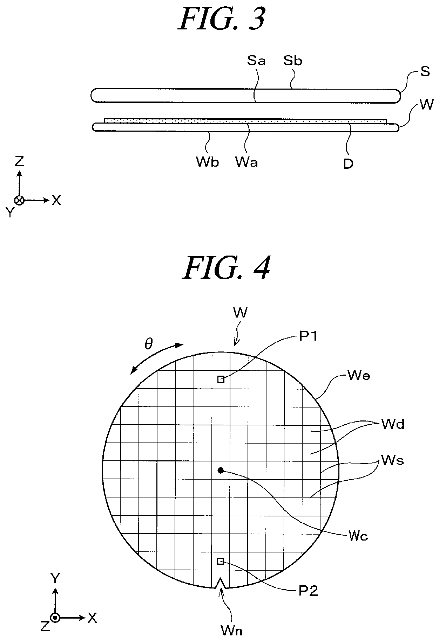

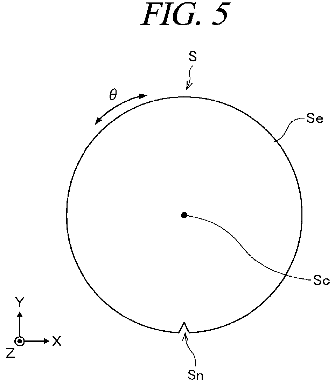

In the substrate processing system 1, a first substrate and a second substrate as two sheets of substrates are bonded together to obtain a combined substrate, as shown in **FIG. 3.** In the following description, the first substrate and the second substrate may be simply referred to as "wafers." In the present exemplary embodiment, the first substrate is a device wafer W as shown in **FIG. 4,** and the second substrate is a support wafer S as shown in **FIG. 5.** A combined wafer T is an example of a combined substrate. In the device wafer W, a surface bonded to the support wafer S is referred to as a front surface Wa, and a surface opposite the front surface Wa is referred to as a rear surface Wb. Likewise, in the support wafer S, a surface bonded to the device wafer W is referred to as a front surface Sa, and a surface opposite the front surface Sa is referred to as a rear surface Sb.

The device wafer W is, for example, a semiconductor wafer such as a silicon substrate, and has, on the front surface Wa, a device layer D including a plurality of circuits, and the like. A notch Wn is formed on an edge We of the device wafer W. Further, a first reference point $P_1$ and a second reference point $P_2$, whose coordinate positions are already known with a center Wc of the device wafer W as an origin, are formed on the device wafer W. In one exemplary embodiment, the first reference point $P_1$ and the second reference point $P_2$ are alignment marks formed when a pattern is formed during the formation of the device layer D. In another exemplary embodiment, the first reference point $P_1$ and the second reference point $P_2$ are selected points on scribe lines Ws.

In addition, as shown in **FIG. 4,** a dicing process is performed on the device wafer W, and the device wafer W is divided into a plurality of dies Wd by the scribe lines Ws (sometimes referred to as streets). In the present exemplary embodiment, when viewed from the top, the dies Wd have a rectangular shape, and the scribe lines Ws are formed in a lattice shape. A circuit of the device layer D is formed on a surface of each die Wd, and the dies Wd constitute a circuit formation region in the present disclosure. No circuit is formed on the scribe lines Ws, and the scribe lines Ws constitute a non-circuit formation region in the present disclosure. In addition, no circuit is formed on the edge We of the device wafer W radially outside the dies Wd and the scribe lines Ws.

The support wafer S is a wafer that supports the device wafer W. The support wafer S is made of a material that transmits infrared light, such as a silicon wafer. A notch Sn is formed on an edge Se of the support wafer S.

Further, the combination of the two substrates bonded by the substrate processing system 1 is not limited to the above example, and any required combination of substrates can be bonded. In one exemplary embodiment, both the first substrate and the second substrate may be device wafers W. In another exemplary embodiment, the first substrate is the device wafer W, and the second substrate is an epitaxial wafer.

In the following description, the device wafer W as the first substrate is located on the lower side, and the support wafer S as the second substrate is located on the upper side. However, this arrangement is for convenience of explanation, and the present exemplary embodiment is not limited thereto.

The substrate processing system 1 has a configuration in which a carry-in/out station 2 and a processing station 3 are connected as a single structure, as illustrated in **FIG.** 1. In the carry-in/out station 2, cassettes $C_W$, $C_S$, and $C_T$ capable of accommodating a plurality of device wafers W, a plurality of support wafers S, and a plurality of combined wafers T, respectively, are carried to/from, for example, the outside. The processing station 3 is equipped with various types of processing devices each configured to perform a required processing on the wafers W and S and the combined wafer T. Further, in one exemplary embodiment, an inspection station 4 is disposed adjacent to the processing station 3.

The carry-in/out station 2 is provided with a cassette placement table 10. The cassette placement table 10 is equipped with a multiple number of, for example, four cassette placement plates 11. The cassette placement plates 11 are arranged in a single row in the horizontal Y-axis direction (up-and-down direction in **FIG.** 1). When carrying the cassettes $C_W$, $C_S$, and $C_T$ to/from the outside of the substrate processing system 1, the cassettes $C_W$, $C_S$, and $C_T$ can be placed on these cassette placement plates 11. In this way, the carry-in/out station 2 is configured to be able to hold the plurality of support wafers S, the plurality of device wafers W, and the plurality of combined wafers T. Here, the number of the cassette placement plates 11 is not limited to the present exemplary embodiment, but may be selected as required. In addition, one of the cassettes may be used for collecting defective wafers. That is, it is a cassette that can separate a defective wafer, which has abnormality in bonding between the support wafer S and the device wafer W due to various factors, from other normal combined wafers T. In the present exemplary embodiment, among multiple cassettes $C_T$, one is used to collect the defective wafer, and the other is used to collect the normal combined wafers T.

In the carry-in/out station 2, a wafer transfer section 20 is provided adjacent to the cassette placement table 10. The wafer transfer section 20 is provided with a wafer transfer device 22 that is movable on a transfer path 21 extending in the Y-axis direction. The wafer transfer device 22 is configured to be movable vertically and around a vertical axis (Z-axis), and is capable of transferring the wafers W and S and the combined wafers T between the cassettes $C_W$, $C_S$, and $C_T$ on the respective cassette placement plates 11 and transition devices 50 and 51 of a third processing block G3 of the processing station 3 to be described later.

The processing station 3 includes multiple, for example, three processing blocks G1, G2, and G equipped with various devices. For example, the first processing block G1 is provided on the front side (negative Y-axis side in **FIG.** 1) of the processing station 3, and the second processing block G2 is provided on the rear side (positive Y-axis side in **FIG.** 1) of the processing station 3. In addition, the third processing block G3 is provided on the carry-in/out station 2 side (negative X-axis side in **FIG.** 1) of the processing station 3.

A surface modifying apparatus 30 for modifying the front surface Wa of the wafer W and the front surface Sa of the wafer S is disposed in the first processing block G1. In the surface modifying apparatus 30, a processing gas, such as an oxygen gas or a nitrogen gas, is excited into plasma and ionized under, for example, a decompressed atmosphere. The surfaces Wa and Sa are irradiated with the oxygen ions or nitrogen ions, so that the surfaces Wa and Sa are plasma-processed and modified.

In the second processing block G2, a surface hydrophilizing apparatus 40 for hydrophilizing and cleaning the surfaces Wa and Sa of the wafers W and S with, for example, pure water, and a bonding apparatus 41 for bonding the wafers W and S are arranged in this order in the horizontal X-axis direction from the carry-in/out station 2 side. A configuration of the bonding apparatus 41 will be described later.

In the surface hydrophilizing apparatus 40, while rotating the wafers W and S held by, for example, a spin chuck, the pure water is supplied onto the wafers W and S. Then, the supplied pure water is diffused onto the surfaces Wa and Sa of the wafers W and S, hydrophilizing the surfaces Wa and Sa.

In the third processing block G3, the transition devices 50 and 51 for the wafers W and S and the combined wafer T are arranged sequentially in two stages from the bottom, as illustrated in **FIG. 2.**

As shown in **FIG. 1**, a wafer transfer section 60 is formed in the area surrounded by the first to third processing blocks G1 to G3. In the wafer transfer section 60, a wafer transfer device 61, for example, is disposed.

The wafer transfer device 61 has a transfer arm configured to be movable in a vertical direction, horizontal directions (X- and Y-axis directions), and around a vertical axis (Z-axis). The wafer transfer device 61 can move in the wafer transfer section 60 to transfer the wafers W and S and the combined wafer T to the selected devices in the first to third processing blocks G1 to G3 around the wafer transfer section 60. Furthermore, the wafer transfer device 61 can also transfer the wafers W and S and the combined wafer T to the inspection station 4.

The substrate processing system 1 described above is provided with a control device 70 as a controller. The control device 70 processes computer-executable commands that cause the substrate processing system 1 to perform various processes described in the present disclosure. The control device 70 may be configured to control the individual components of the substrate processing system 1 to perform the various processes described herein. In one exemplary embodiment, a part or the whole of the control device 70 may be included in the substrate processing system 1. The control device 70 may include a processor, a storage, and a communication interface. The control device 70 is implemented by, for example, a computer. The processor may be configured to read out from the storage a program providing logic or routines that enable various control operations, and to perform the various control operations by executing the read program. This program may be previously stored in the storage, or may be acquired via a medium when necessary. The acquired program is stored in the storage, and read from the storage and executed by the processor. The medium may be any of various types of computer-readable recording media H, or may be a communication line connected to the communication interface. The recording medium H may be transitory or non-transitory. The processor may be a CPU (Central Processor Unit) or may be one or more circuits. The storage may include a RAM (Random Access Memory), a ROM (Read Only Memory), an HDD (Hard Disk Drive), an SSD (Solid State Drive), or a combination thereof. The communication interface may communicate with the substrate processing system 1 via a communication line such as a LAN (Local Area Network).

The inspection station 4 provided in one exemplary embodiment is equipped with an inspection apparatus 80. Details of the inspection apparatus 80 will be described later.

<Configuration of bonding apparatus>

Now, the configuration of the aforementioned bonding apparatus 41 will be explained. **FIG.** 4 is a transversal sectional view schematically illustrating the configuration of the bonding apparatus 41. **FIG. 5** is a longitudinal sectional view schematically illustrating the configuration of the bonding apparatus 41.

(Overall configuration of bonding apparatus)

The bonding apparatus 41 has a processing vessel 100 having a sealable inside, as shown in **FIG. 4** and **FIG. 5.** A carry-in/out opening 101 for the wafers W and S and the combined wafer T is formed in a side surface of the processing vessel 100 near the wafer transfer section 60, and an opening/closing shutter 102 is provided at the carry-in/out opening 101.

The interior of the processing vessel 100 is divided into a transfer section R1 and a processing section R2 by an inner wall 103. The aforementioned carry-in/out opening 101 is formed in the side surface of the processing vessel 100 in the transfer section R1. Further, the inner wall 103 is provided with a carry-in/out opening 104 for the wafers W and S and the combined wafer T.

A transition 110 for temporarily placing the wafers W and S and the combined wafer T is provided on the positive Y-axis side of the transfer section R1. The transition 110 is formed in two stages, for example, and is capable of placing any two of the wafers W and S and the combined wafers T.

In the transfer section R1, a wafer transfer mechanism 111 is provided. The wafer transfer mechanism 111 has a transfer arm that is movable in a vertical direction, horizontal directions (X- and Y-axis directions), and around a vertical axis (Z-axis). Further, the wafer transfer mechanism 111 can transfer the wafers W and S and the combined wafer T within the transfer section R1 or between the transfer section R1 and the processing section R2.

On the negative Y-axis side of the transfer section R1, a position adjusting mechanism 120 for adjusting directions of the wafers W and S in a horizontal direction are provided. The position adjusting mechanism 120 has a base 121 equipped with a holder (not shown) for holding and rotating the wafers W and S, and a detector 122 for detecting positions of the notches of the wafers W and S. In the position adjusting mechanism 120, while rotating the wafers W and S held on the base 121, the positions of the notches of the wafers W and S are detected by the detector 122, thereby adjusting the position of the notch, and the directions of the wafers W and S in the horizontal direction are adjusted by adjusting the positions of the notches. Here, the way to hold the wafers W and S on the base 121 is not particularly limited, and various methods such as a pin chuck method or a spin chuck method may be used, for example.

Furthermore, in the transfer section R1, an inverting mechanism 130 configured to invert the front and rear surfaces of the support wafer S is provided. The inverting mechanism 130 has a holding arm 131 for holding the support wafer S. The holding arm 131 extends in a horizontal direction (X-axis direction). Further, holding members 132 for holding the support wafer S are provided at, for example, four locations on the holding arm 131.

The holding arm 131 is supported by a driver 133 equipped with, for example, a motor. By this driver 133, the holding arm 131 is rotatable around a horizontal axis. Further, the holding arm 131 is rotatable around the driver 133 and movable in a horizontal direction (X-axis direction). Below the driver 133, there is provided another driver (not shown) equipped with, for example, a motor. By this other driver, the driver 133 can be moved vertically along a support column 134 that extends in a vertical direction. In this way, the support wafer S held by the holding members 132 can be rotated around the horizontal axis and moved in the vertical and horizontal directions by the driver 133. In addition, the support wafer S held by the holding members 132 can be rotated around the driver 133 and moved between the position adjusting mechanism 120 and an upper chuck 141 to be described.

In the processing section R2, there are provided a lower chuck 140 as a first holder that places the device wafer W on a top surface thereof while attracting and holding it, and the upper chuck 141 as a second holder that attracts and holds the support wafer S on a bottom surface thereof. The lower chuck 140 is disposed below the upper chuck 141 and is configured to be positioned to face the upper chuck 141. That is, the device wafer W held on the lower chuck 140 and the support wafer S held on the upper chuck 141 can be positioned to face each other.

The upper chuck 141 is supported by an upper chuck stage 150 that is provided above the upper chuck 141. The upper chuck stage 150 is provided with an upper imaging device 151 that that images the front surface Wa of the device wafer W held on the lower chuck 140. That is, the upper imaging device 151 is disposed adjacent to the upper chuck 141. By way of example, a CCD camera is used for the upper imaging device 151.

The upper chuck stage 150 is supported by a rotation device 153 as a moving mechanism provided on a ceiling surface of the processing vessel 100 via a plurality of support members 152 above the upper chuck stage 150. The rotation device 153 is configured to rotate the upper chuck stage 150 and the upper chuck 141 around a vertical axis (Z-axis). The rotation device 153 includes, by way of example, a driver 153a which is a servo driver and a motor 153b which is a servo motor.

The rotation device 153 is provided with a linear scale 154 as a measuring device. The linear scale 154 measures a $\theta$ azimuth (corresponding to a rotational position about the Z-axis) of the upper chuck 141. In addition, the linear scale 154 measures a $\theta$ azimuth of the rotation device 153, but as the rotation device 153, the support member 152, the upper chuck stage 150, and the upper chuck 141 are rigid bodies, the linear scale 154 substantially measure the $\theta$ azimuth of the upper chuck 141.

Moreover, the configuration for rotating the upper chuck 141 and the configuration for measuring the azimuth angle $\theta$ of the upper chuck 141 are not limited to the present exemplary embodiment and may be designed as required.

The lower chuck 140 is supported by a lower chuck stage 160 disposed below the lower chuck 140. The lower chuck stage 160 is provided with a lower imaging device 161 for imaging the front surface Sa of the support wafer S held on the upper chuck 141. That is, the lower imaging device 161 is located adjacent to the lower chuck 140. By way of example, a CCD camera is used for the lower imaging device 161.

The lower chuck stage 160 is supported by a first lower chuck mover 164 as a moving mechanism provided below the lower chuck stage 160. The first lower chuck mover 164 is configured to move the lower chuck 140 in a horizontal direction (X-axis direction) as will be described later. Also, the first lower chuck mover 164 is configured to move the lower chuck 140 in a vertical direction (Z-axis direction) as well. In addition, the first lower chuck mover 164 includes, by way of example, a driver 164a which is a servo driver and a motor 164b which is a servo motor. In addition, in the present exemplary embodiment, the first lower chuck mover 164 moves the lower chuck 140 in the X-axis direction and the Z-axis direction, but a mover for moving the lower chuck 140 in the X-axis direction and a mover for moving the lower chuck 140 in the Z-axis direction may be provided separately.

The first lower chuck mover 164 is mounted to a pair of rails 165 provided on a bottom side of the first lower chuck mover 164 and extending in a horizontal direction (X-axis direction). The first lower chuck mover 164 is configured to be movable along the rails 165.

The pair of rails 165 are installed on a second lower chuck mover 166 as a moving mechanism. The second lower chuck mover 166 is mounted to a pair of rails 167 provided on a bottom side of the second lower chuck mover 166 and extending in a horizontal direction (Y-axis direction). The second lower chuck mover 166 is configured to be movable along the rails 167, that is, to move the lower chuck 140 in the horizontal direction (Y-axis direction). Further, the second lower chuck mover 166 includes, by way of example, a driver 166a which is a servo driver and a motor 166b which is a servo motor. In addition, the pair of rails 167 are installed on a placement table 168 disposed on a bottom surface of the processing vessel 100.

In addition, the configuration for moving the lower chuck 140 in the X-axis, Y-axis and Z-axis directions and the configuration for measuring the positions of the lower chuck 140 in the X-axis, Y-axis and Z-axis directions are not limited to the present exemplary embodiment, and may be designed as required.

(Configuration of upper chuck and lower chuck)

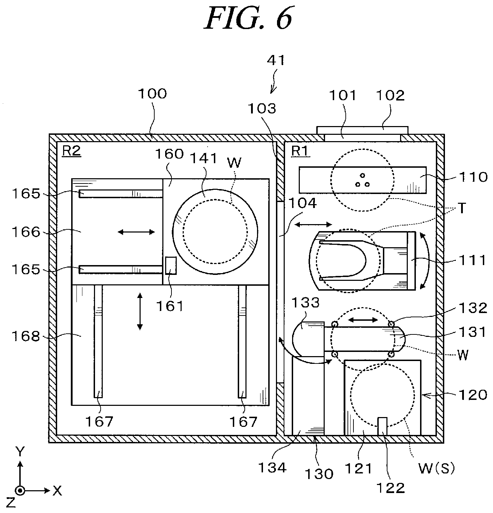

Now, a detailed configuration of the lower chuck 140 and the upper chuck 141 of the bonding apparatus 41 will be described. **FIG.** 6 is a longitudinal sectional view schematically showing the configuration of the upper chuck 141 and the lower chuck 140.

As depicted in **FIG.** 6, the upper chuck 141 adopts a pin chuck method. The upper chuck 141 has a main body 170 with a diameter equal to or larger than that of the support wafer S when viewed from the top. A plurality of pins 171 configured to be brought into contact with the rear surface Wb of the support wafer S are provided on a bottom surface of the main body 170. Further, an outer rib 172 having the same height as the pins 171 and supporting an edge of the rear surface Wb of the support wafer S is provided on an edge of the bottom surface of the main body 170. The outer rib 172 is provided in an annular shape outside the plurality of pins 171.

Furthermore, on the bottom surface of the main body 170, an inner rib 173 having the same height as the pins 171 and supporting the rear surface Wb of the support wafer S is provided inside the outer rib 172. The inner rib 173 is provided in an annular shape to be concentric with the outer rib 172. In addition, a region 174 inside the outer rib 172 (hereinafter, sometimes referred to as a suction region 174) is divided into a first suction region 174a inside the inner rib 173 and a second suction region 174b outside the inner rib 173.

In the first suction region 174a, first suction openings 175a for suctioning the support wafer S are formed in the bottom surface of the main body 170. The first suction openings 175a are formed at, for example, four locations in the first suction region 174a. First suction lines 176a provided inside the main body 170 are connected to the first suction openings 175a. Furthermore, a first vacuum pump 177a is connected to the first suction lines 176a.

In addition, in the second suction region 174b, second suction openings 175b for suctioning the support wafer S are provided in the bottom surface of the main body 170. The second suction openings 175b are formed at, for example, two locations in the second suction region 174b. Second suction lines 176b provided inside the main body 170 are connected to the second suction openings 175b. Furthermore, a second vacuum pump 177b is connected to the second suction lines 176b.

By evacuating the suction regions 174a and 174b, which are formed by being surrounded by the support wafer S, the main body 170, and the outer rib 172, through the suction openings 175a and 175b, the suction regions 174a and 174b are decompressed. At this time, since the atmosphere outside the suction regions 174a and 174b is under an atmospheric pressure, the support wafer S is pressed toward the suction regions 174a and 174b by the atmospheric pressure as much as the reduced pressure, so that the support wafer S is attracted to and held by the upper chuck 141. Further, the upper chuck 141 is configured such that the support wafer S can be vacuum-suctioned in the first suction region 174a and the second suction region 174b independently.

A through hole 178 is formed in a central portion of the main body 170 of the upper chuck 141 and a central portion of the upper chuck stage 150 so as to be extended through the main body 170 and the upper chuck stage 150 in a thickness direction. The central portion of the main body 170 corresponds to a central portion of the support wafer S that is attracted to and held by the upper chuck 141. A leading end of an actuator 181 of a pressing device 180 to be described later is inserted through the through hole 178.

The pressing device 180 configured to press the central portion of the support wafer S is provided on a top surface of the upper chuck stage 150. The pressing device 180 has the actuator 181 as a contact member and a cylinder 182.

The actuator 181 generates a constant pressure in a certain direction by air supplied from an electropneumatic regulator (not shown), and is capable of generating the pressure at a constant level regardless of the position of an acting point of the pressure. Furthermore, the actuator 181 can control a pressing load applied to the central portion of the support wafer S when it comes into contact with the central portion of the support wafer S with the air from the electropneumatic regulator. Furthermore, the leading end of the actuator 181 can be moved up and down through the through hole 178 by the air from the electropneumatic regulator.

The actuator 181 is supported by the cylinder 182. The cylinder 182 is capable of moving the actuator 181 in a vertical direction by a driver having, for example, a motor embedded therein.

As described above, the pressing device 180 controls the pressing load by the actuator 181 and controls the movement of the actuator 181 by the cylinder 182. In addition, the pressing device 180 is capable of pressing the central portions of the support wafer S and the device wafer W into contact with each other when bonding the wafers W and S as will be described later.

The lower chuck 140, like the upper chuck 141, employs a pin chuck method. The lower chuck 140 has a main body 190 with a diameter equal to or larger than that of the device wafer W when viewed from the top. A plurality of pins 191 configured to be brought into contact with the rear surface Sb of the device wafer W are provided on a top surface of the main body 190. Further, an outer rib 192 having the same height as the pins 191 and supporting an edge of the rear surface Sb of the device wafer W is provided on an edge of the top surface of the main body 190. The outer rib 192 is provided in an annular shape outside the plurality of pins 191.

Furthermore, on the top surface of the main body 190, an inner rib 193 having the same height as the pins 191 and supporting the rear surface Sb of the device wafer W is provided inside the outer rib 192. The inner rib 193 is provided in an annular shape to be concentric with the outer rib 192. In addition, a region 194 inside the outer rib 192 (hereinafter, sometimes referred to as a suction region 194) is divided into a first suction region 194a inside the inner rib 193 and a second suction region 194b outside the inner rib 193.

In the first suction region 194a, a first suction opening 195a for vacuum-suctioning the device wafer W is formed in the top surface of the main body 190. The first suction opening 195a is formed at, for example, a single location in the first suction region 194a. A first suction line 196a provided inside the main body 190 is connected to the first suction opening 195a. Furthermore, a first vacuum pump 197a is connected to the first suction line 196a.

In addition, in the second suction region 194b, second suction openings 195b for vacuum-suctioning the device wafer W are provided in the top surface of the main body 190. The second suction openings 195b are formed at, for example, two locations in the second suction region 194b. Second suction lines 196b provided inside the main body 190 are connected to the second suction openings 195b. Furthermore, a second vacuum pump 197b is connected to the second suction lines 196b.

By evacuating the suction regions 194a and 194b, which are formed by being surrounded by the device wafer W, the main body 190, and the outer rib 192, through the suction openings 195a and 195b, the suction regions 194a and 194b are decompressed. At this time, since the atmosphere outside the suction regions 194a and 194b is under an atmospheric pressure, the device wafer W is pressed toward the suction regions 194a and 194b by the atmospheric pressure as much as the reduced pressure, so that the device wafer W is attracted to and held by the lower chuck 140. Further, the lower chuck 140 is configured such that the device wafer W can be suctioned in the first suction region 194a and the second suction region 194b independently.

In the lower chuck 140, through holes (not shown) are formed at, for example, three locations near a central portion of the main body 190 so as to be extended through the main body 190 in a thickness direction. Elevating pins provided below the first lower chuck mover 164 are inserted through these through holes.

Guide members (not shown) are provided on an edge of the main body 190 to suppress the wafers W and S and the combined wafer T from sticking out or slipping off the lower chuck 140. The guide members are provided at an equal distance at multiple locations, for example, four locations, on the edge of the main body 190.

Furthermore, the operations of the individual components in the bonding apparatus 41 are controlled by the control device 70 described above.

<Bonding method>

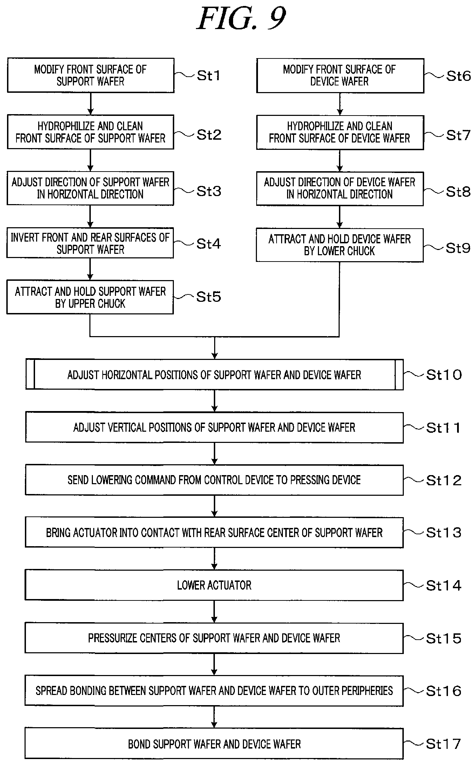

Now, a bonding method for the wafers W and S performed by using the substrate processing system 1 configured as described above will be described. **FIG.** 9 is a flowchart showing main processes of a wafer bonding processing.

First, the cassette $C_W$ accommodating a plurality of device wafers W, the cassette $C_S$ accommodating a plurality of support wafers S, and the empty cassette $C_T$ are placed on the selected cassette placement plates 11 of the carry-in/out station 2. Thereafter, the support wafer S in the cassette $C_S$ is taken out by the wafer transfer device 22 and transferred to the transition device 50 of a third processing block G3 of the processing station 3.

Then, the support wafer S is transferred to the surface modifying apparatus 30 of the first processing block G1 by the wafer transfer device 61. In the surface modifying apparatus 30, under a required decompressed atmosphere, the oxygen gas or the nitrogen gas, which is the processing gas, is excited into plasma to be ionized. The front surface Sa of the support wafer S is irradiated with oxygen ions or nitrogen ions, so that the front surface Sa is plasma-processed. The front surface Sa of the support wafer S is then modified (St1 in **FIG.** 9).

Next, the support wafer S is transferred to the surface hydrophilizing apparatus 40 of the second processing block G2 by the wafer transfer device 61. In the surface hydrophilizing apparatus 40, pure water is supplied onto the support wafer S while rotating the support wafer S held by the spin chuck. Then, the supplied pure water is diffused on the front surface Sa of the support wafer S, and hydroxyl groups (silanol groups) adhere to the front surface Sa of the support wafer S modified in the surface modifying apparatus 30, thereby making the front surface Sa hydrophilic. In addition, the front surface Sa of the support wafer S is cleaned by the pure water (St2 in **FIG. 9**).

Thereafter, the support wafer S is transferred to the bonding apparatus 41 of the second processing block G2 by the wafer transfer device 61. The support wafer S transferred to the bonding apparatus 41 is sent to position adjusting mechanism 120 by the wafer transfer device 111 via the transition 110. Then, the direction of the support wafer S in the horizontal direction is adjusted by the position adjusting mechanism 120 (St3 in **FIG. 9**).

Afterwards, the support wafer S is transferred from the position adjusting mechanism 120 to the holding arm 131 of the inverting mechanism 130. Subsequently, in the transfer region R1, the holding arm 131 is inverted, thereby inverting the front and rear surfaces of the support wafer S (St4 in **FIG. 9**). That is, the front surface Sa of the support wafer S is turned to face downward.

Thereafter, the holding arm 131 of the inverting mechanism 130 is rotated around the driver 133 and is moved to below the upper chuck 141. Then, the support wafer S is passed from the inverting mechanism 130 to the upper chuck 141. The rear surface Wb of the support wafer S is attracted to and held on the upper chuck 141 (St5 in **FIG. 9**). Specifically, by operating the vacuum pumps 177a and 177b, the support wafer S is vacuum-suctioned through the suction openings 175a and 175b in the suction regions 174a and 174b, so that the support wafer S is attracted to and held by the upper chuck 141.

While the above-described processes St1 to St5 are being performed on the support wafer S, the device wafer W is processed following the support wafer S. First, the device wafer W in the cassette $C_W$ is taken out by the wafer transfer device 22 and transferred to the transition device 50 of the processing station 3.

Next, the device wafer W is transferred to the surface modifying apparatus 30 by the wafer transfer device 61, where the front surface Wa of the device wafer W is modified (St6 in **FIG. 9**). The modification of the front surface Wa of the device wafer W in the process St6 is the same as in the process St1 described above.

Thereafter, the device wafer W is transferred to the surface hydrophilizing apparatus 40 by the wafer transfer device 61, where the front surface Wa of the device wafer W is hydrophilized and the front surface Sa is cleaned (St7 in **FIG. 9**). The hydrophilization and cleaning of the front surface Wa of the device wafer W in the process St7 are the same as in the process St2 described above.

Afterwards, the device wafer W is transferred to the bonding apparatus 41 by the wafer transfer device 61. The device wafer W carried into the bonding apparatus 41 is transferred to the position adjusting mechanism 120 by the wafer transfer mechanism 111 via the transition 110. The direction of the device wafer W in the horizontal direction is then adjusted by the position adjusting mechanism 120 (St8 in **FIG. 9**).

Subsequently, the device wafer W is transferred to the lower chuck 140 by the wafer transfer mechanism 111, and its rear surface Wb is attracted to and held on the lower chuck 140 (St9 in **FIG. 9**). To elaborate, by operating the vacuum pumps 197a and 197b, the device wafer W is vacuum-suctioned through the suction openings 195a and 195b in the suction regions 194a and 194b, so that the device wafer W is attracted to and held on the lower chuck 140.

Next, the horizontal positions of the device wafer W held by the lower chuck 140 and the support wafer S held by the upper chuck 141 are adjusted (St10 in **FIG. 9**). In the process St10, the horizontal positions of the device wafer W and the support wafer S are adjusted based on the center Wc of the device wafer W and a center Sc of the support wafer S, which are obtained by performing a first sub-process or a second sub-process to be described later.

In the process St10, the center Sc of the support wafer S is obtained as follows, for example. First, the front surface Sa of the support wafer S is imaged by using the lower imaging device 161 to acquire imaging data. Then, the center Sc of the support wafer S can be determined by using a known algorithm in the image analysis of the imaging data. As an example, a point having the same distance from arbitrary points on the edge Se of the support wafer S in the imaging data is determined as the center Sc of the support wafer S.

(First sub-process)

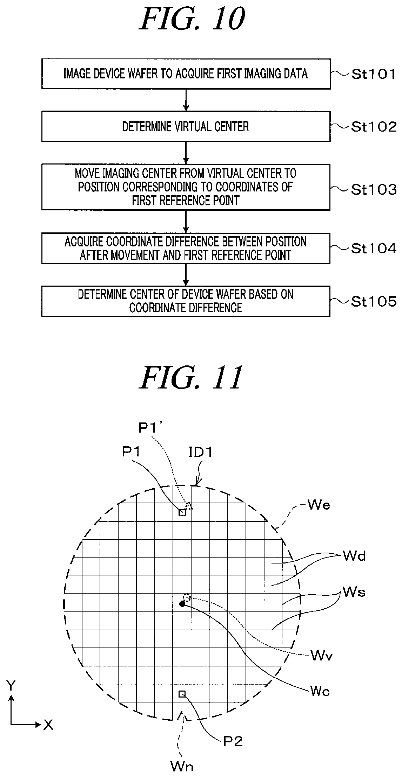

In one exemplary embodiment, in the horizontal position adjustment (St10 of **FIG. 9**), the first sub-process shown in **FIG. 10** is performed. In the first sub-process, the device wafer W is imaged by using the upper imaging device 151, and the center Wc of the device wafer W is obtained. In various types of imaging data in the present specification, images of respective elements on the surface of the wafer are obtained. In the following description, for the images of each element on the imaging data, the name and the notation of each element are simply described, and the description of "image of ~" is omitted. In addition, the image of the center Wc of the device wafer W on the imaging data is not actually obtained, but is illustrated for the conveniences' sake to explain its positional relationship with a virtual center Wv to be described later. In addition, there may be cases where the image of the scribe line Ws on the imaging data is not actually obtained.

In a movement process of an imaging center Mc, for example, movement distances of the moving mechanisms of the upper imaging device 151 and the lower imaging device 161 are stored, and the imaging center Mc may be determined by calculating coordinate information of a start point and an end point of each movement, a coordinate difference, a direction (vector), or the like.

In the first sub-process, first, the front surface Wa of the device wafer W is imaged by using the upper imaging device 151, and first imaging data ID1 as shown in **FIG. 11** is acquired (St101 in **FIG. 10).**

Then, based on the first imaging data ID1, the virtual center Wv of the device wafer W is determined (St102 in **FIG. 10).** The virtual center Wv can be determined by using a commonly known algorithm in image analysis of the first imaging data ID1. As an example, a point having the same distance from arbitrary points on the edge We of the device wafer W in the first imaging data ID1 is determined as the virtual center Wv. At this time, as shown in **FIG. 11,** the center Wc of the device wafer W and the virtual center Wv do not necessarily coincide. This is assumed to be because a portion of the edge We or the notch Wn may be deformed or damaged. Due to such deformation or damage, the image of the edge We or the notch Wn in the first imaging data ID1 may become unclear, as indicated by dashed lines in **FIG. 11.** When the center is determined from such an unclear image by using the known algorithm, the center Wc and the virtual center Wv may not be coincident with each other.

Next, the imaging center Mc of the upper imaging device 151 is moved from the virtual center Wv to a position $P_1'$ corresponding to the coordinates of the first reference point $P_1$ with the virtual center Wv as the origin (St103 in **FIG. 10).** As described above, the coordinates of the first reference point $P_1$ with the center Wc of the device wafer W as the first substrate as the origin are already known.

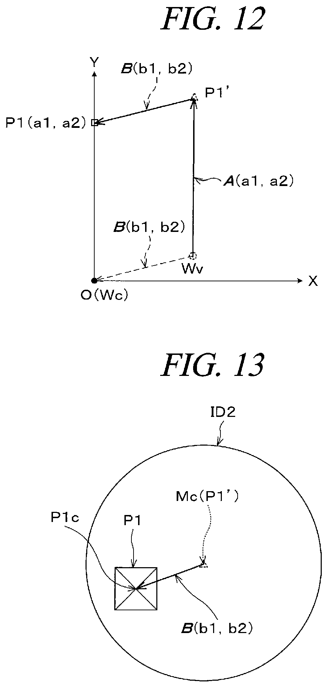

A control of the movement of the imaging center Mc of the upper imaging device 151 in the process St103 will be explained with reference to **FIG. 12. FIG. 12** is an X-Y orthogonal coordinate system with the center Wc on an in-plane surface of the device wafer W as an origin O. In **FIG. 12,** the coordinates of the first reference point $P_1$ in the X-Y orthogonal coordinate system are set to (a1, a2) for the conveniences' sake. At this time, in the process St103, the imaging center Mc is moved by a vector A (a1, a2) with the virtual center Wv as a start point.

Next, at the position $P_1'$ after the movement of the imaging center Mc of the upper imaging device 151, the front surface Wa of the device wafer W is imaged to acquire second imaging data ID2. The second imaging data ID2 includes the first reference point $P_1$. Then, based on the second imaging data ID2, a coordinate difference between the first reference point $P_1$ and the position $P_1'$ after the movement of the imaging center Mc is measured and determined (St104 **in FIG. 10).** For example, this coordinate difference can be obtained as a vector B(b1, b2) shown in **FIG. 12** from the relative position between the first reference point $P_1$ and the position $P_1'$ after the movement of the imaging center Mc.

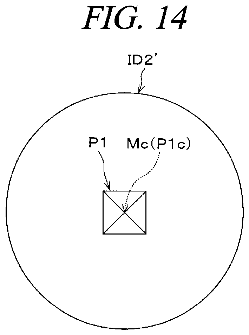

In the process St104 according to one exemplary embodiment, the imaging center Mc is moved from the position $P_1'$ after the movement of the process St103 to a center $P_1c$ of the first reference point P1, as shown in **FIG. 13.** In **FIG. 14,** the imaging center Mc in an imaging data ID2' acquired after the movement and the center $P_1c$ of the first reference point $P_1$ overlap. The center $P_1c$ of the first reference point $P_1$ may be determined by using a known algorithm in the image analysis of the second imaging data ID2. In addition, whether the imaging center Mc and the center $P_1c$ of the first reference point P1 overlap can be determined using a known algorithm in the image analysis of the imaging data ID2' during the movement. In addition, the actual movement amount (vector B) from the position $P_1'$ to the center $P_1c$ of the first reference point $P_1$ is recorded, and this movement amount is determined as the coordinate difference between the position $P_1'$ and the first reference point $P_1$.

After the process St104, the same control as the processes St101 to St104 may be performed for the second reference point $P_2$ to acquire another coordinate difference. Then, an average value of multiple coordinate differences based on these multiple reference points may be set as a representative value and used as a coordinate difference in a process St105 to be described later.

Thereafter, based on the coordinate difference acquired in the process St104, the virtual center Wv is corrected, and the center Wc of the device wafer W is determined (St105 in **FIG. 10).** As an example of the correction of the virtual center Wv, in **FIG. 12,** an end point of the vector B (b1, b2) with the virtual center Wv as a start point may be determined, and this end point may be determined as the center Wc of the device wafer W.

(Second sub-process)

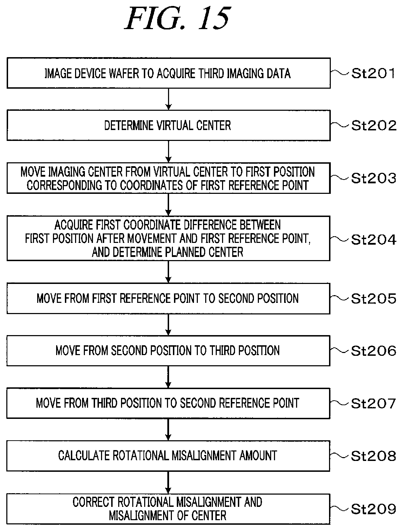

In another exemplary embodiment, in the horizontal position adjustment (St10 of **FIG.** 9), the second sub-process illustrated in **FIG. 15** is performed. **FIG. 15** is a flowchart schematically illustrating an outline of the second sub-process.

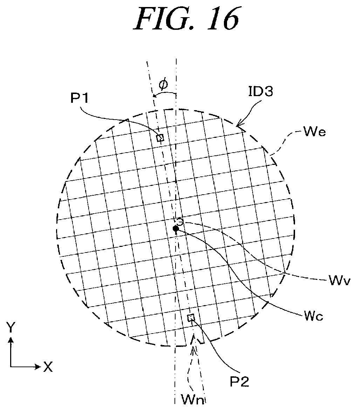

In the second sub-process, first, the front surface Wa of the device wafer W is imaged by using the upper imaging device 151 to acquire third imaging data ID3 as illustrated in **FIG. 16** (St201 in **FIG. 15).** On the device wafer W according to the present exemplary embodiment, the first reference point $P_1$, the second reference point $P_2$, the center Wc, and the notch Wn are provided in a single straight line shape. A straight line $P_1P_2$ passing through these points is indicated by a dashed dotted line in **FIG.** 16. In addition, the first reference point $P_1$ and the second reference point $P_2$ are provided at positions 180 degrees symmetrical with respect to the center Wc. In the present exemplary embodiment, the device wafer W is arranged with respect to the lower chuck 140 while being rotationally misaligned by $\phi$ in the counterclockwise direction around the center Wc of the device wafer W. Therefore, an image of each element on the third imaging data ID3 is obtained while being rotationally misaligned by $\phi$ in the counterclockwise direction. In addition, the rotational misalignment amount $\phi$ is a misalignment amount from a normal azimuth angle on the lower chuck 140. This normal azimuth angle is indicated by a dashed double dotted line in **FIG.** 16. In one exemplary embodiment, the arrangement position (azimuth angle) of the device wafer W on the lower chuck 140 is determined by referring to the notch Wn before placing the device wafer W on the lower chuck 140. As described above, the notch Wn may be obtained as an unclear image, and in such a case, the azimuth angle of the device wafer W may be deviated from the normal azimuth angle, as in the present exemplary embodiment.

Next, based on the third imaging data ID3, the virtual center Wv of the device wafer W is determined (St202 in **FIG. 15).** This determination of the virtual center Wv is the same as in the process St102 of the first sub-process. At this time, as shown in **FIG.** 16, the center Wc of the device wafer W and the virtual center Wv do not necessarily coincide. That is, in addition to the rotational misalignment, a misalignment occurs between the center Wc and the virtual center Wv for the same reason as described in the first sub-process.

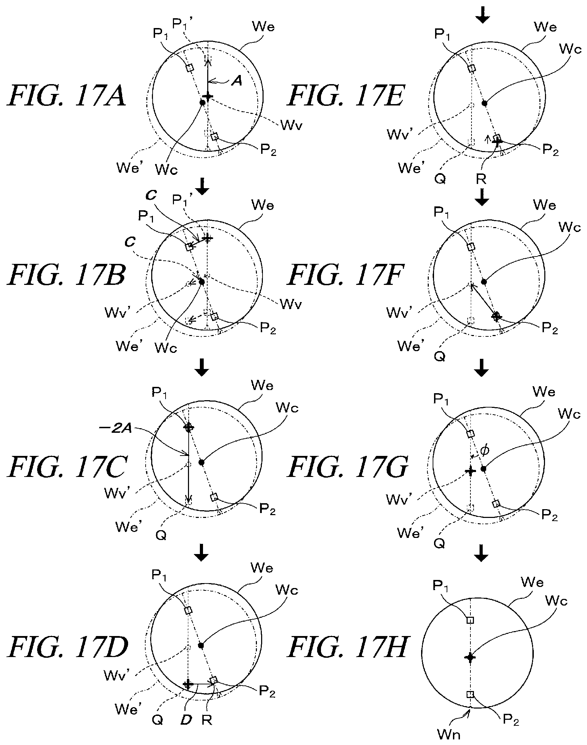

**FIG. 17A to FIG. 17H** are diagrams showing the positional relationship between the device wafer W and the imaging center Mc in respective process states of the second sub-process. **FIG. 17A** to **FIG. 17H** show a time series when performing respective processes of the second sub-process in sequence. In each state diagram of **FIG. 17A** to **FIG. 17H,** elements that are actually imaged (that is, whose images are formed on the imaging data) by the upper imaging device 151 are indicated by solid lines. However, although the center Wc is not actually imaged, it is illustrated as a black dot to ease the understanding of the positional relationship. A dashed-dotted circle is a circle centered on the center Wc, and is a virtual edge We' when there is no deformation or damage in the edge We of the device wafer W. In the present exemplary embodiment, as a result of deformation or damage in the edge We, the edge We indicated by a solid-line circle is imaged. The virtual center Wv is determined based on this edge We in the process St202, and as a result, the virtual center Wv is deviated from the center Wc. Furthermore, the imaging center Mc in each state diagram is indicated by a bold-line cross.

In a movement process of the imaging center Mc, movement distances in the moving mechanisms of the upper imaging device 151 and the lower imaging device 161 may be stored, and the imaging center Mc may be determined by calculating coordinate information of a start point and an end point of each movement, a coordinate difference, a direction (vector), or the like.

Next, the imaging center Mc of the upper imaging device 151 is moved from the virtual center Wv to the first position $P_1$' corresponding to the original coordinates of the first reference point $P_1$ when the virtual center Wv is set as the origin (St203 in **FIG. 15** and **FIG. 17A).** The control of the movement of the imaging center Mc of the upper imaging device 151 in the process St203 is the same as in the process St103 of the first sub-process.

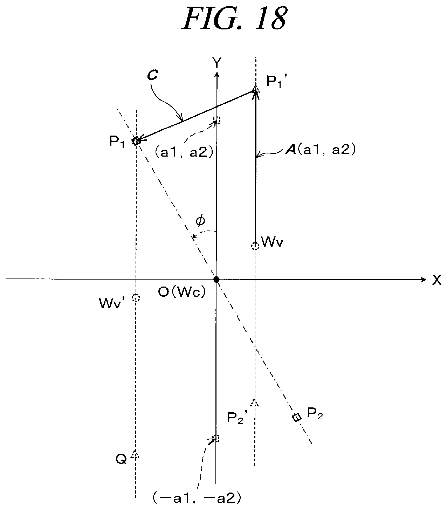

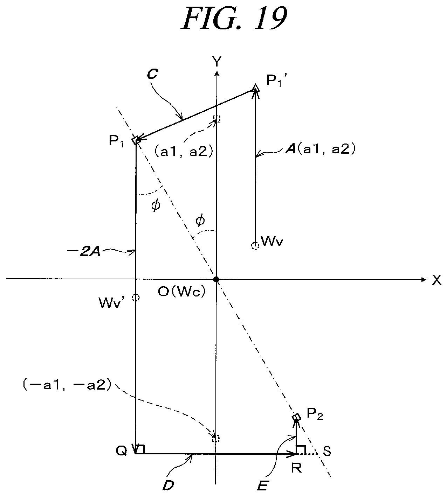

**FIG. 18** and **FIG. 19** are X-Y orthogonal coordinate systems in which the center Wc on the in-plane surface of the device wafer W is defined as the origin O, and the straight line $P_1P_2$ overlaps with the Y-axis when the device wafer W is positioned at a normal azimuth angle. In **FIG. 18** and **FIG. 19,** the original coordinates of the first reference point $P_1$ in the X-Y orthogonal coordinate system are set to (a1, a2) for the conveniences' sake. In the present exemplary embodiment, since the first reference point $P_1$ and the second reference point $P_2$ are arranged at positions rotationally symmetrical by 180 degrees with respect to the center Wc, the original coordinates of the second reference point $P_2$ become (-a1, -a2). Here, the 'original coordinates of the first reference point $P_1$' and the 'original coordinates of the second reference point $P_2$' refer to the known coordinates of the first reference point $P_1$ and the second reference point $P_2$ with the center Wc as the origin when there is no rotational misalignment of the angle $\phi$. At this time, in the process St203, the imaging center Mc is moved by the vector A (a1, a2) with the virtual center Wv as a start point.

Next, the front surface Wa of the device wafer W is imaged at the first position $P_1$' after the movement of the imaging center Mc of the upper imaging device 151 to acquire fourth imaging data ID4. The fourth imaging data ID4 includes the first reference point $P_1$. Thereafter, based on the fourth imaging data ID4, a first coordinate difference between the first reference point $P_1$ and the first position $P_1$' after the movement of the imaging center Mc is measured and determined (St204 in **FIG. 15** and **FIG. 17B).** In **FIG. 17B,** the first coordinate difference can be obtained as a vector C from the relative position between the first reference point $P_1$ and the first position $P_1$' after the movement of the imaging center Mc, for example. Specific method for determining the first coordinate difference is the same as in the St104 of the first sub-process. After determining the first coordinate difference, the imaging center Mc may overlap the first reference point $P_1$.

Further, in the process St204, the position of the end point of vector C, with the virtual center Wv as the start point, is also determined as a planned center Wv'. Like the virtual center Wv, the planned center Wv' does not appear as an image on the imaging data because it is virtual coordinate information used in the analysis of the imaging data; however, it is illustrated for the convenience of explanation.

Next, in **FIG. 19,** the imaging center Mc of the upper imaging device 151 is moved to a second position Q by a vector from the original coordinates of the first reference point $P_1$ to the original coordinates of the second reference point P2, with the first reference point $P_1$ as a start point (St205 in **FIG. 15** and **FIG. 17C).** The control of the movement of the imaging center Mc of the upper imaging device 151 in the process St205 is the same as in the process St103 of the first sub-process. In the present exemplary embodiment, the vector from the first reference point $P_1$ to the second reference point $P_2$ is defined as a vector -2A.

Thereafter, with the second position Q as a start point, the imaging center Mc of the upper imaging device 151 is moved by a vector D, which is directed toward the direction of the second reference point $P_2$ and is orthogonal to a straight line $P_1Q$ (St206 in **FIG. 15** and **FIG. 17D).** The movement of the imaging center Mc stops at a third position R. The third position R is the closest point to the second reference point $P_2$ on a straight line that is orthogonal to the straight line $P_1Q$ and passes through the second position Q. Further, when moving the imaging center Mc with the second position Q as the start point, a process of determining, when viewed from the second position Q, whether the second reference point $P_2$ is located on the positive X-axis side or the negative X-axis side may be performed. In this process, the determination may be made based on the third imaging data ID3, for example.

**Subsequently,** with the third position R as a start point, the imaging center Mc of the upper imaging device 151 is moved by a vector E which is directed toward the second reference point $P_2$ and is orthogonal to a straight line QR (St207 in **FIG. 15** and **FIG. 17E).** The control of the movement of the imaging center Mc of the upper imaging device 151 in the process St205 is the same as in the process St103 of the first sub-process.

Next, a rotational misalignment amount $\phi$ is calculated (St208 in **FIG.** 15). The rotational misalignment amount $\phi$ can be geometrically determined based on the coordinate information, the coordinate differences, the vectors, or the like obtained in the above-described processes. By way of example, an intersection point between the straight line QR and the straight line $P_1P_2$ is set as S as a virtual point for calculation. For the rotational misalignment amount $\phi$, the following Expression (1) is satisfied.

[Expression 1]

$$\tan \phi = (QR + RS) / P_1Q \quad \cdots (1)$$

In Expression (1), $P_1Q$, QR, and RS are the lengths of a line segment $P_1Q$, a line segment QR, and a line segment RS, respectively. Among these, for the line segment RS, a point S is a virtual point, and the length of the line segment RS cannot be measured from the imaging data. Here, since Expression (2) is obtained from the similarity between a triangle $P_1QS$ and a triangle $P_2RS$, the length of RS can be obtained. In Expressions (1) and (2), $P_1Q$, QR, and $P_2R$ are known because their values can be obtained as movement amounts when the imaging center Mc is moved during the respective processes.

[Expression 2]

$$RS = \frac{\dfrac{QR}{P_1Q}}{\dfrac{1}{P_2R} - \dfrac{1}{P_1Q}} \quad \cdots (2)$$

The value of the rotational misalignment amount $\phi$ can be obtained by an inverse trigonometric function (arctan) of $\tan\phi$ calculated from Expressions (1) and (2).

Then, based on the obtained value of the rotational misalignment amount $\phi$, the rotational misalignment of the device wafer W and the misalignment of the center Wc are corrected (St209 in FIG. 15 and **FIG. 17F** to **FIG. 17H).** Correction of the rotational misalignment and the misalignment of the center Wc are performed concurrently, as described below. First, the imaging center Mc is moved to the planned center Wv' **(FIG. 17F).** Next, the imaging center Mc is rotated by the angle $\phi$ about the first reference point $P_1$ in a direction in which the straight line $P_1P_2$ becomes overlapped with the straight line $P_1Q$ **(FIG. 17G).** By this rotation, the center Wc will overlap the imaging center Mc after the correction. Therefore, the imaging center Mc after the rotation can be determined as the center Wc **(FIG. 17H).**

According to the first sub-process or the second sub-process above, by determining the center Wc of the device wafer W, the horizontal position with respect to the center Sc of the support wafer S, which is obtained in advance, can be adjusted.

In one exemplary embodiment, the actual position of the notch Wn of the device wafer W is determined based on the center Wc of the device wafer W obtained by the first sub-process or the second sub-process. In the present exemplary embodiment, the notch Wn is known to be provided at the edge We on the straight line passing through the first reference point $P_1$, the second reference point $P_2$, and the center Wc. Accordingly, based on the first reference point $P_1$, the second reference point $P_2$ and the center Wc obtained by the first sub-process or the second sub-process, a position of the edge We on the straight line connecting them can be determined as the actual position of the notch Wn **(FIG. 17H).**

Hereinafter, the technical significance of the first sub-process or the second sub-process will be described.

**As** described above, the first substrate in the present exemplary embodiment is the device wafer W on which the device layer D is formed, and the second substrate is the support wafer S on which no device layer D is formed. In the device wafer W having the device layer D formed thereon, a portion of the edge We or the notch Wn may be deformed or damaged due to such a process as etching or trimming.

For the device wafer W in which the portion of the edge We or the notch Wn is deformed or damaged, the virtual center Wv is determined in the processes St101 and St102 of the first sub-process, for example. In a known algorithm, such as that described in the process St102, the virtual center Wv is determined as a position having the same distance from arbitrary points on the edge We. Therefore, if the portion of the edge We or the notch Wn as the reference is deformed or damaged, the obtained virtual center Wv may be deviated from the actual center Wc.

Meanwhile, according to the first sub-process or the second sub-process of the present exemplary embodiment, even if the portion of the edge We or the notch Wn is deformed or damaged, the actual center Wc can be obtained from the virtual center Wv based on the coordinate difference.

Further, when the portion of the edge We or the notch Wn is deformed or damaged, the device wafer W may be arranged on the lower chuck 140 in a rotationally misaligned state. This is because, in processes up to the transfer of the device wafer W to the lower chuck 140, the azimuth angle of the device wafer W may be determined by referring to the notch Wn. Even in such a case, according to the second sub-process of the present exemplary embodiment, after correcting the rotational misalignment, the actual center Wc can be obtained from the virtual center Wv.

Moreover, even if the notch Wn is deformed or damaged, the actual position of the notch Wn can be obtained based on the obtained center Wc of the device wafer W according to the first sub-process or the second sub-process of the present exemplary embodiment.

Also, although the present exemplary embodiment has been described for a case where the second substrate is the support wafer S, the present exemplary embodiment is not limited thereto. In one exemplary embodiment, when both the first substrate and the second substrate are device wafers W, the first sub-process or the second sub-process is performed for each of the first and second substrates to obtain their centers.

The first reference point $P_1$ and the second reference point $P_2$ may be provided at the positions a certain distance away from the center Wc of the device wafer W, without being limited thereto. When the distance of the first reference point $P_1$ and the second reference point $P_2$ from the center Wc is far, the movement distance of the imaging center Mc becomes long in the movement of the process St103, St203, or St205 to St207. In such a case, the influence of the rotational misalignment and the center misalignment may increase. That is, the coordinate difference between the position $P_1$' or $P_2$' of the imaging center Mc after the movement and the first or second reference point $P_1$ or $P_2$ greatly reflects the influence of the rotational misalignment and the center misalignment. By obtaining this coordinate difference, the influence of the rotational misalignment and the center misalignment can be accurately evaluated, and the center Wc can be more accurately calculated.

In addition, the first reference point $P_1$ and the second reference point $P_2$ are alignment marks in the present exemplary embodiment, but are not limited thereto. In one exemplary embodiment, when the upper imaging device 151 can capture an image of the scribe line Ws of the device wafer W, and the scribe line Ws can be observed in the imaging data to perform the image analysis, points on the scribe line Ws whose coordinate positions are known with the center Wc as the origin can be set as the first reference point $P_1$ and the second reference point $P_2$.

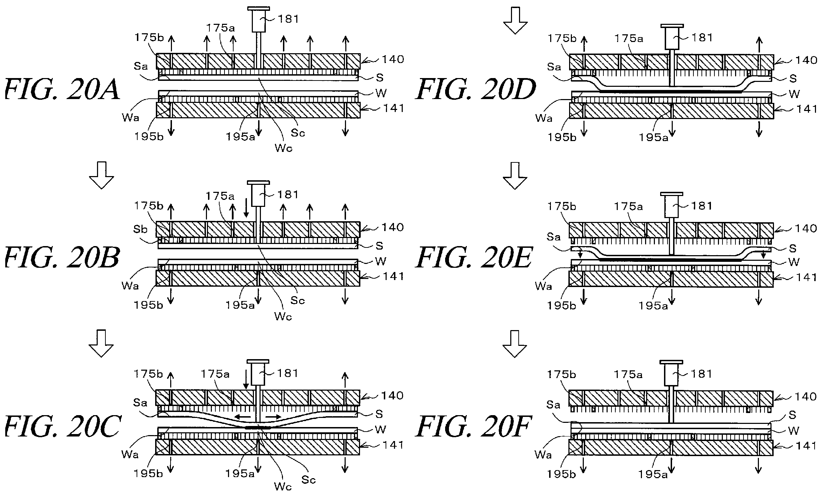

Returning to **FIG. 9,** the lower chuck 140 is then moved vertically upward by the first lower chuck mover 164, thereby adjusting the vertical positions of the upper chuck 141 and the lower chuck 140 to adjust the vertical positions of the support wafer S held by the upper chuck 141 and the device wafer W held by the lower chuck 140 (St11 in **FIG.** 9). Then, as shown in **FIG.** 20A, the support wafer S and the device wafer W are arranged at required positions, facing each other.

Thereafter, a bonding processing between the support wafer S held by the upper chuck 141 and the device wafer W held by the lower chuck 140 is performed.

First, a lowering command is output from the control device 70 to the pressing device 180 (St12 in **FIG.** 9), and in response to this lowering command, the pressing device 180 lowers the actuator 181 by the cylinder 182. As the actuator 181 is lowered, the actuator 181 comes into contact with a central portion of the rear surface Sb of the support wafer S as shown in **FIG. 20B** (St13 in **FIG.** 9), and the center Sc of the support wafer S is pressed and lowered (St14 in **FIG.** 9). Then, as shown in **FIG. 20C,** the central portion of the support wafer S and the center Wc of the device wafer W are pressurized into contact with each other by the pressing device 180 (St15 in **FIG.** 9). At this time, the operation of the first vacuum pump 177a is stopped, thereby stopping the vacuum-suctioning of the support wafer S through the first suction openings 175a in the first suction region 174a, and while the second vacuum pump 177b remains in operation, the second suction region 174b is vacuum-suctioned through the second suction openings 175b. With this configuration, even when the center Sc of the support wafer S is pressed by the pressing device 180, the edge of the support wafer S can still be held by the upper chuck 141.

When the center Sc of the support wafer S and the center Wc of the device wafer W are brought into pressurized contact with each other, bonding is initiated between the centers Sc and Wc (see a bold-line portion in **FIG. 20C).** That is, since the front surface Sa of the support wafer S and the front surface Wa of the device wafer W have been modified in the processes St1 and S6, respectively, a van der Waals force (intermolecular force) is generated between the front surfaces Wa and Sa, so that the front surfaces Wa and Sa are bonded together. In addition, since the front surface Sa of the support wafer S and the front surface Wa of the device wafer W have been hydrophilized in the processes St2 and St7, respectively, the hydrophilic groups between the front surfaces Wa and Sa are hydrogen-bonded (intermolecular force), so that the front surfaces Wa and Sa are firmly bonded to each other. As shown in **FIG. 20D,** the bonding by the van der Waals force and the hydrogen bonding between the above-described front surfaces Wa and Sa spreads from the centers Sc and Wc toward the edges (St16 in **FIG.** 9).

Thereafter, as illustrated in **FIG. 20E,** while the center Sc of the support wafer S and the center Wc of the device wafer W are pressurized by the pressing device 180, the operation of the second vacuum pump 177b is stopped, thereby stopping the vacuum-suctioning of the support wafer S through the second suction openings 175b in the second suction region 174b. Then, the edge of the support wafer S falls onto the device wafer W. As a result, the entire front surface Sa of the support wafer S and the entire front surface Wa of the device wafer W come into contact with each other, as illustrated in **FIG. 20F,** so that the support wafer S and the device wafer W are bonded together (St17 in **FIG.** 9).

Thereafter, the actuator 181 of the pressing device 180 is raised up to the upper chuck 141. Further, by stopping the operation of the vacuum pumps 197a and 197b, the vacuum-suctioning of the device wafer W in the suction region 194 is stopped, thereby stopping the attracting and holding of the device wafer W by the lower chuck 140.

The combined wafer T in which the support wafer S and the device wafer W are bonded is transferred to the transition device 51 by the wafer transfer device 61, and then transferred to the cassette $C_T$ of the selected cassette placement plate 11 by the wafer transfer device 22 of the carry-in/out station 2. In this way, the series of processes of the bonding processing between the wafers W and S are completed.

**<Inspection** apparatus>

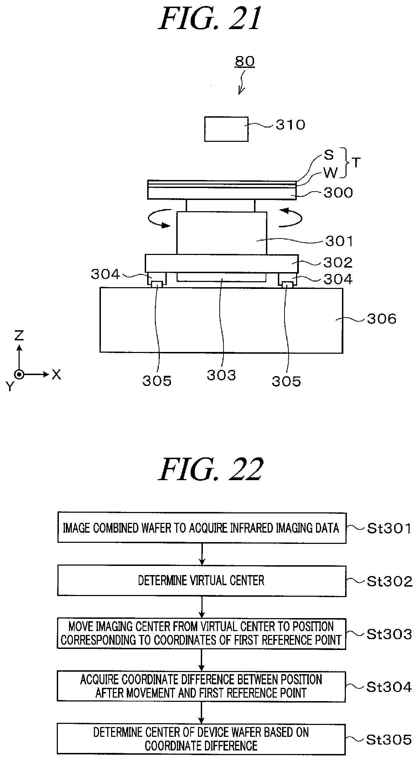

Now, the inspection apparatus 80 according to the present exemplary embodiment will be described. **FIG. 21** is a side view schematically illustrating a configuration of the inspection apparatus 80 according to the present exemplary embodiment. The inspection apparatus 80 is capable of inspecting the soundness of the bonding state of the combined wafer T obtained by the substrate processing system described above.

The inspection apparatus 80 has a chuck 300 that holds the combined wafer T on a top surface thereof. The chuck 300 attracts and holds the combined wafer T. The chuck 300 is supported by a slider table 302 with an air bearing 301 therebetween. A rotating mechanism 303 is provided on a bottom side of the slider table 302. The rotating mechanism 303 has, for example, a motor as a driving source embedded therein. The chuck 300 is configured to be rotatable around the Z-axis (vertical axis) via the air bearing 301 by the rotating mechanism 303. The slider table 302 is configured to be movable along a rail 305, which is provided on a base 306 and extending in the Y-axis direction, by a moving mechanism 304 provided on the bottom side of the slide table 302. In addition, the driving source of the moving mechanism 304 is not particularly limited. In one exemplary embodiment, another slider table, another moving mechanism, and another rail may be provided to move the chuck 300 in the X-axis direction as well.

An infrared imaging device 310 is disposed above the chuck 300. The infrared imaging device 310 images the combined wafer T attracted to and held by the chuck 300. At this time, the infrared imaging device 310 is configured to image the edge Se and the notch Sn of the support wafer S located at the upper side in the combined wafer T, and the first and second reference points $P_1$ and $P_2$ of the device wafer W located at the lower side. In one exemplary embodiment, the infrared imaging device 310 includes a commonly known IR camera.

**<Inspection** method of bonding state>

Now, an inspection method of inspecting a bonding state according to the present exemplary embodiment will be described with reference to **FIG. 22. FIG. 22** is a flowchart schematically illustrating an outline of the inspection method of inspecting a bonding state according to the present exemplary embodiment. This inspection method of inspecting the bonding state according to the present exemplary embodiment may be performed in the inspection apparatus 80 described above. Further, the inspection method may also be performed in a selected inspection apparatus outside the system, which has the configuration as the inspection apparatus 80.

In a process St301, the combined wafer T is imaged from the front surface Sa side of the support wafer S by using the infrared imaging device 310, thereby acquiring infrared imaging data IRD (St301 in **FIG. 22).**

Then, the center Sc of the support wafer S is determined. The center Sc of the support wafer S may be obtained by using a known algorithm in image analysis of infrared imaging data IRD. As an example, a point having the same distance from arbitrary points on the edge Se of the support wafer S on the infrared imaging data IRD may be defined as the center Sc of the support wafer S.

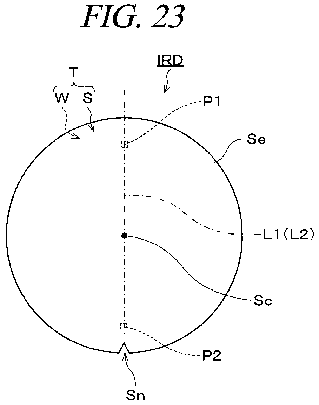

Next, a first straight line L1 connecting the center Sc and the notch Sn of the support wafer S and a second straight line L2 connecting the first reference point $P_1$ and the second reference point $P_2$ of the device wafer W are drawn, and an angle $\psi$ formed by the two lines is obtained. In an example of **FIG. 23,** the first straight line L1 and the second straight line L2 overlap, and the angle $\psi$ formed by the two lines is approximately 0 (zero) degrees.

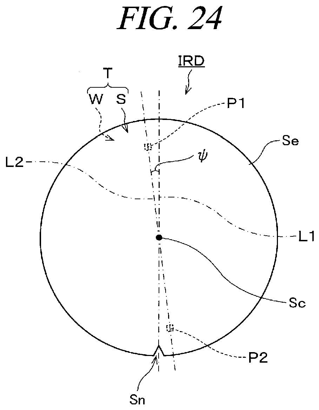

**FIG. 24** shows the infrared imaging data IRD of the combined wafer T as a reference example formed by bonding the support wafer S and the device wafer W in a rotationally misaligned state. In the combined wafer T shown in **FIG. 24,** the first straight line L1 and the second straight line L2 do not overlap, and the angle $\psi$ formed by the two lines is greater than 0 (zero) degrees.

Next, by comparing the angle $\psi$ formed by the first straight line L1 and the second straight line L2 with a required threshold value, it is determined whether the angle $\psi$ is within the range of the threshold value. In one exemplary embodiment, in the combined wafer T shown in **FIG. 23,** the angle $\psi$ formed by the first straight line L1 and the second straight line L2 is approximately 0 (zero) degrees and is determined to be within the range of the threshold value. Thus, the combined wafer T is determined to be acceptable (normal). On the other hand, in the combined wafer T shown in **FIG. 24,** the angle $\psi$ formed by the first straight line L1 and the second straight line L2 is great and is determined to be outside the range of the threshold value. Thus, the combined wafer T is determined to be unacceptable.

In one exemplary embodiment, the combined wafer T determined to be unacceptable is stored as an abnormal wafer in the cassette $C_T$ different from a cassette where the combined wafer T determined to be normal is stored.

In addition, in the present exemplary embodiment, the range of the threshold value is set to several degrees around 0 (zero) degrees, but is not limited thereto. In one exemplary embodiment, in a case where an intersection between the first straight line L1 and the second straight line L2 at the angle $\psi$ within a range of several degrees around 90 degrees is regarded as being acceptable, the threshold value may be defined as a range of several degrees around 90 degrees. In addition, a range of several degrees around a selected angle may be defined as the threshold value.

It should be noted that the above-described exemplary embodiments are illustrative in all aspects and are not anyway limiting. The above-described exemplary embodiments may be omitted, replaced and modified in various ways without departing from the scope and the spirit of claims. For example, the constitutional elements of the above-described exemplary embodiments may be combined in various ways. From any of these various combinations, functions and effects for the respective constituent elements are naturally obtained, and other functions and other effects obvious to those skilled in the art are also obtained from the description of the present specification.

In addition, the effects described in the present specification are only explanatory or illustrative and are not limiting. That is, the technique according to the present disclosure may exhibit, together with or instead of the above-stated effects, other effects obvious to those skilled in the art from the description of the present specification.

Furthermore, the following configuration examples are also within the technical scope of the present disclosure.

(1) A substrate processing system, including:

a bonding apparatus bonding substrates together; and
control circuitry,
wherein the bonding apparatus includes:

a first holder holding a first substrate;
a second holder disposed below or above the first holder, and holding a second substrate;
a contact member bringing a center of the first substrate and a center of the second substrate into contact with each other;
an imaging device imaging at least the first substrate; and
a moving mechanism moving the first holder, the second holder, and the imaging device relative to one another,
the first substrate has at least one reference point, coordinates of which are known with the center of the first substrate as an origin, and
the control circuitry executes a control including:

(a) a process of imaging the first substrate to determine a virtual center of the first substrate;
(b) a process of moving an imaging center of the imaging device from the virtual center to a position corresponding to the coordinates of the reference point when the virtual center is set as an origin;
(c) a process of imaging the first substrate at the position to which the imaging center has been moved in the process (b) to obtain a coordinate difference between the imaging center and the reference point;
(d) a process of correcting the virtual center to obtain the center of the first substrate; and
(e) a process of bringing the center of the first substrate obtained in the process (d) into contact with the center of the second substrate.

(2) The substrate processing system described in (1),
wherein in the process (d), the control circuitry obtains the center of the first substrate by correcting the virtual center based on the coordinate difference acquired in the process (c).

(3) The substrate processing system described in (1),

wherein the first substrate has two or more of the reference points, and

the control circuitry executes the control including:
(f) a process of moving the imaging center to a reference point after the process (c) to obtain a rotational misalignment amount of the first substrate.

(4) The substrate processing system described in (3),
wherein in the process (d), the control circuitry obtains the center of the first substrate by correcting the virtual center by rotation based on the rotational misalignment amount acquired in the process (f).
(5) The substrate processing system described in any one of (1) to (4),
wherein at least the first substrate is a substrate on which pattern formation is performed, and the reference point is an alignment mark in the pattern formation.
(6) The substrate processing system described in any one of (1) to (5),

wherein the imaging device images the second substrate,
the moving mechanism moves the second holder and the imaging device relative to each other,
the second substrate has at least one reference point, coordinates of which are known with the center of the second substrate as an origin, and
the control circuitry executes the control including:

(g) a process of imaging the second substrate to determine a virtual center of the second substrate;
(h) a process of moving the imaging center of the imaging device from the virtual center of the second substrate to a position corresponding to the coordinates of the reference point of the second substrate when the virtual center of the second substrate is set as an origin;
(i) a process of imaging the second substrate at the position to which the imaging center has been moved in the process (h) to obtain a coordinate difference between the imaging center and the reference point of the second substrate; and
(j) a process of correcting the virtual center of the second substrate to obtain the center of the second substrate.

(7) The substrate processing system described in (6),
wherein the first substrate and the second substrate are substrates on which pattern formation is performed, and the reference point of the first substrate and the reference point of the second substrate are alignment marks in the pattern formation.
(8) The substrate processing system described in any one of (1) to (7), further including:

an inspection apparatus inspecting a combined substrate in which the first substrate and the second substrate are bonded,
wherein the second substrate has a notch on an edge thereof,
the inspection apparatus includes:

a third holder holding the combined substrate;
an inspection imaging device imaging the combined substrate; and
a moving mechanism moving the third holder and the inspection imaging device relative to each other, and
the control circuitry executes the control including:

(p) a process of transferring the combined substrate to the inspection apparatus after the process (e), and imaging the second substrate from a second substrate side of the combined substrate to determine a center of the combined substrate;
(q) a process of acquiring an angle formed by a first straight line connecting the center of the combined substrate and the notch of the second substrate, and a second straight line connecting the center of the combined substrate and the reference point of the first substrate; and
(r) a process of comparing the angle with a threshold value to determine whether the angle is within a range of the threshold value.

(9) The substrate processing system described in (8),
wherein the control circuitry executes the control including:
(s) a process of when the angle is beyond the range of the threshold value, determining that a bonding state of the combined substrate is unacceptable, and processing the combined substrate as an abnormal substrate.
(10) A bonding apparatus, including:

a first holder holding a first substrate;

a second holder disposed below or above the first holder, and holding a second substrate;

a contact member bringing a center of the first substrate and a center of the second substrate into contact with each other;

an imaging device imaging at least the first substrate;

a moving mechanism moving the first holder, the second holder, and the imaging device relative to one another; and

control circuitry,

wherein the first substrate has at least one reference point, coordinates of which are known with the center of the first substrate as an origin, and

the control circuitry executes a control including:

(a) a process of imaging the first substrate to determine a virtual center of the first substrate;

(b) a process of moving an imaging center of the imaging device from the virtual center to a position corresponding to the coordinates of the reference point when the virtual center is set as an origin;

(c) a process of imaging the first substrate at the position to which the imaging center has been moved in the process (b) to obtain a coordinate difference between the imaging center and the reference point;

(d) a process of correcting the virtual center to obtain the center of the first substrate; and

(e) a process of bringing the center of the first substrate obtained in the process (d) into contact with the center of the second substrate.

(11) A bonding method of bonding a first substrate and a second substrate using a bonding apparatus, wherein the bonding apparatus includes:

a first holder holding the first substrate;

a second holder disposed below or above the first holder, and holding the second substrate;

a contact member bringing a center of the first substrate and a center of the second substrate into contact with each other;

an imaging device imaging at least the first substrate; and

a moving mechanism moving the first holder, the second holder, and the imaging device relative to one another,

the first substrate has at least one reference point, coordinates of which are known with the center of the first substrate as an origin, and

the bonding method includes:

(a) a process of imaging the first substrate to determine a virtual center of the first substrate;

(b) a process of moving an imaging center of the imaging device from the virtual center to a position corresponding to the coordinates of the reference point when the virtual center is set as an origin;

(c) a process of imaging the first substrate at the position to which the imaging center has been moved in the process (b) to obtain a coordinate difference between the imaging center and the reference point;

(d) a process of correcting the virtual center to obtain the center of the first substrate; and

(e) a process of bringing the center of the first substrate obtained in the process (d) into contact with the center of the second substrate.

**EXPLANATION OF CODES**

1: Substrate processing system
41: Bonding apparatus
70: Control device
140: Lower chuck
141: Upper chuck
151: Upper imaging device
151: Rotation device
154: Linear scale
161: Lower imaging device
164: First lower chuck mover
166: Second lower huck mover

181: Actuator
W: Device wafer
Wc: Center
S: Support wafer
Sc: Center
$P_1$: First reference point
Mc: Imaging center

**Claims**

1. A substrate processing system, comprising:

    a bonding apparatus bonding substrates together; and
    control circuitry,
    wherein the bonding apparatus comprises:

        a first holder holding a first substrate;
        a second holder disposed below or above the first holder, and holding a second substrate;
        a contact member bringing a center of the first substrate and a center of the second substrate into contact with each other;
        an imaging device imaging at least the first substrate; and
        a moving mechanism moving the first holder, the second holder, and the imaging device relative to one another,
        the first substrate has at least one reference point, coordinates of which are known with the center of the first substrate as an origin, and
        the control circuitry executes a control including:

            (a) a process of imaging the first substrate to determine a virtual center of the first substrate;
            (b) a process of moving an imaging center of the imaging device from the virtual center to a position corresponding to the coordinates of the reference point when the virtual center is set as an origin;
            (c) a process of imaging the first substrate at the position to which the imaging center has been moved in the process (b) to obtain a coordinate difference between the imaging center and the reference point;
            (d) a process of correcting the virtual center to obtain the center of the first substrate; and
            (e) a process of bringing the center of the first substrate obtained in the process (d) into contact with the center of the second substrate.

2. The substrate processing system of Claim 1,
    wherein in the process (d), the control circuitry obtains the center of the first substrate by correcting the virtual center based on the coordinate difference acquired in the process (c).

3. The substrate processing system of Claim 1,

    wherein the first substrate has two or more of the reference points, and
    the control circuitry executes the control including:
    (f) a process of moving the imaging center to a reference point after the process (c) to obtain a rotational misalignment amount of the first substrate.

4. The substrate processing system of Claim 3,
    wherein in the process (d), the control circuitry obtains the center of the first substrate by correcting the virtual center by rotation based on the rotational misalignment amount acquired in the process (f).

5. The substrate processing system of any one of Claims 1 to 4,
    wherein at least the first substrate is a substrate on which pattern formation is performed, and the reference point is an alignment mark in the pattern formation.

6. The substrate processing system of any one of Claims 1 to 4,

wherein the imaging device images the second substrate,

the moving mechanism moves the second holder and the imaging device relative to each other,

the second substrate has at least one reference point, coordinates of which are known with the center of the second substrate as an origin, and

the control circuitry executes the control including:

(g) a process of imaging the second substrate to determine a virtual center of the second substrate;

(h) a process of moving the imaging center of the imaging device from the virtual center of the second substrate to a position corresponding to the coordinates of the reference point of the second substrate when the virtual center of the second substrate is set as an origin;

(i) a process of imaging the second substrate at the position to which the imaging center has been moved in the process (h) to obtain a coordinate difference between the imaging center and the reference point of the second substrate; and

(j) a process of correcting the virtual center of the second substrate to obtain the center of the second substrate.

7. The substrate processing system of Claim 6,

wherein the first substrate and the second substrate are substrates on which pattern formation is performed, and the reference point of the first substrate and the reference point of the second substrate are alignment marks in the pattern formation.

8. The substrate processing system of any one of Claims 1 to 3, further comprising:

an inspection apparatus inspecting a combined substrate in which the first substrate and the second substrate are bonded,

wherein the second substrate has a notch on an edge thereof,

the inspection apparatus comprises:

a third holder holding the combined substrate;

an inspection imaging device imaging the combined substrate; and

a moving mechanism moving the third holder and the inspection imaging device relative to each other, and

the control circuitry executes the control including:

(p) a process of transferring the combined substrate to the inspection apparatus after the process (e), and imaging the second substrate from a second substrate side of the combined substrate to determine a center of the combined substrate;

(q) a process of acquiring an angle formed by a first straight line connecting the center of the combined substrate and the notch of the second substrate, and a second straight line connecting the center of the combined substrate and the reference point of the first substrate; and

(r) a process of comparing the angle with a threshold value to determine whether the angle is within a range of the threshold value.

9. The substrate processing system of Claim 8,

wherein the control circuitry executes the control including:

(s) a process of when the angle is beyond the range of the threshold value, determining that a bonding state of the combined substrate is unacceptable, and processing the combined substrate as an abnormal substrate.

10. A bonding apparatus, comprising:

a first holder holding a first substrate;

a second holder disposed below or above the first holder, and holding a second substrate;

a contact member bringing a center of the first substrate and a center of the second substrate into contact with each other;

an imaging device imaging at least the first substrate;

a moving mechanism moving the first holder, the second holder, and the imaging device relative to one another; and

control circuitry,

wherein the first substrate has at least one reference point, coordinates of which are known with the center of the first substrate as an origin, and
the control circuitry executes a control including:

(a) a process of imaging the first substrate to determine a virtual center of the first substrate;
(b) a process of moving an imaging center of the imaging device from the virtual center to a position corresponding to the coordinates of the reference point when the virtual center is set as an origin;
(c) a process of imaging the first substrate at the position to which the imaging center has been moved in the process (b) to obtain a coordinate difference between the imaging center and the reference point;
(d) a process of correcting the virtual center to obtain the center of the first substrate; and
(e) a process of bringing the center of the first substrate obtained in the process (d) into contact with the center of the second substrate.

11. A bonding method of bonding a first substrate and a second substrate using a bonding apparatus, wherein the bonding apparatus comprises:

a first holder holding the first substrate;
a second holder disposed below or above the first holder, and holding the second substrate;
a contact member bringing a center of the first substrate and a center of the second substrate into contact with each other;
an imaging device imaging at least the first substrate; and
a moving mechanism moving the first holder, the second holder, and the imaging device relative to one another,
the first substrate has at least one reference point, coordinates of which are known with the center of the first substrate as an origin, and
the bonding method comprises:

(a) a process of imaging the first substrate to determine a virtual center of the first substrate;
(b) a process of moving an imaging center of the imaging device from the virtual center to a position corresponding to the coordinates of the reference point when the virtual center is set as an origin;
(c) a process of imaging the first substrate at the position to which the imaging center has been moved in the process (b) to obtain a coordinate difference between the imaging center and the reference point;
(d) a process of correcting the virtual center to obtain the center of the first substrate; and
(e) a process of bringing the center of the first substrate obtained in the process (d) into contact with the center of the second substrate.

*FIG. 1*

# FIG. 2

## FIG. 3

Sa  Sb

S

W

Wb  Wa  D

Z
Y⊗→X

## FIG. 4

W

θ

P1

We

Wd

Ws

Wc

P2

Wn

Y
Z⊙→X

# FIG. 5

## FIG. 6

# FIG. 7

## FIG. 8

# FIG. 9

MODIFY FRONT SURFACE OF SUPPORT WAFER ~St1

MODIFY FRONT SURFACE OF DEVICE WAFER ~St6

HYDROPHILIZE AND CLEAN FRONT SURFACE OF SUPPORT WAFER ~St2

HYDROPHILIZE AND CLEAN FRONT SURFACE OF DEVICE WAFER ~St7

ADJUST DIRECTION OF SUPPORT WAFER IN HORIZONTAL DIRECTION ~St3

ADJUST DIRECTION OF DEVICE WAFER IN HORIZONTAL DIRECTION ~St8

INVERT FRONT AND REAR SURFACES OF SUPPORT WAFER ~St4

ATTRACT AND HOLD DEVICE WAFER BY LOWER CHUCK ~St9

ATTRACT AND HOLD SUPPORT WAFER BY UPPER CHUCK ~St5

ADJUST HORIZONTAL POSITIONS OF SUPPORT WAFER AND DEVICE WAFER ~St10

ADJUST VERTICAL POSITIONS OF SUPPORT WAFER AND DEVICE WAFER ~St11

SEND LOWERING COMMAND FROM CONTROL DEVICE TO PRESSING DEVICE ~St12

BRING ACTUATOR INTO CONTACT WITH REAR SURFACE CENTER OF SUPPORT WAFER ~St13

LOWER ACTUATOR ~St14

PRESSURIZE CENTERS OF SUPPORT WAFER AND DEVICE WAFER ~St15

SPREAD BONDING BETWEEN SUPPORT WAFER AND DEVICE WAFER TO OUTER PERIPHERIES ~St16

BOND SUPPORT WAFER AND DEVICE WAFER ~St17

## FIG. 10

IMAGE DEVICE WAFER TO ACQUIRE FIRST IMAGING DATA —— St101

DETERMINE VIRTUAL CENTER —— St102

MOVE IMAGING CENTER FROM VIRTUAL CENTER TO POSITION CORRESPONDING TO COORDINATES OF FIRST REFERENCE POINT —— St103

ACQUIRE COORDINATE DIFFERENCE BETWEEN POSITION AFTER MOVEMENT AND FIRST REFERENCE POINT —— St104

DETERMINE CENTER OF DEVICE WAFER BASED ON COORDINATE DIFFERENCE —— St105

## FIG. 11

## FIG. 12

## FIG. 13

## FIG. 14

## *FIG. 15*

| | |
|---|---|
| IMAGE DEVICE WAFER TO ACQUIRE THIRD IMAGING DATA | ~St201 |

↓

| | |
|---|---|
| DETERMINE VIRTUAL CENTER | ~St202 |

↓

| | |
|---|---|
| MOVE IMAGING CENTER FROM VIRTUAL CENTER TO FIRST POSITION CORRESPONDING TO COORDINATES OF FIRST REFERENCE POINT | ~St203 |

↓

| | |
|---|---|
| ACQUIRE FIRST COORDINATE DIFFERENCE BETWEEN FIRST POSITION AFTER MOVEMENT AND FIRST REFERENCE POINT, AND DETERMINE PLANNED CENTER | ~St204 |

↓

| | |
|---|---|
| MOVE FROM FIRST REFERENCE POINT TO SECOND POSITION | ~St205 |

↓

| | |
|---|---|
| MOVE FROM SECOND POSITION TO THIRD POSITION | ~St206 |

↓

| | |
|---|---|
| MOVE FROM THIRD POSITION TO SECOND REFERENCE POINT | ~St207 |

↓

| | |
|---|---|
| CALCULATE ROTATIONAL MISALIGNMENT AMOUNT | ~St208 |

↓

| | |
|---|---|
| CORRECT ROTATIONAL MISALIGNMENT AND MISALIGNMENT OF CENTER | ~St209 |

## FIG. 16

FIG. 17A

FIG. 17B

FIG. 17C

FIG. 17D

FIG. 17E

FIG. 17F

FIG. 17G

FIG. 17H

# FIG. 18

## FIG. 19

EP 4 783 225 A1

FIG. 20A

FIG. 20B

FIG. 20C

FIG. 20D

FIG. 20E

FIG. 20F

## FIG. 21

<u>80</u>

310

$\left. \begin{array}{c} S \\ W \end{array} \right\} T$

300

301

302

304 — 304

306

305     303     305

Z
↑
→ X
Y⊙

## FIG. 22

| IMAGE COMBINED WAFER TO ACQUIRE INFRARED IMAGING DATA | ~St301 |

↓

| DETERMINE VIRTUAL CENTER | ~St302 |

↓

| MOVE IMAGING CENTER FROM VIRTUAL CENTER TO POSITION CORRESPONDING TO COORDINATES OF FIRST REFERENCE POINT | ~St303 |

↓

| ACQUIRE COORDINATE DIFFERENCE BETWEEN POSITION AFTER MOVEMENT AND FIRST REFERENCE POINT | ~St304 |

↓

| DETERMINE CENTER OF DEVICE WAFER BASED ON COORDINATE DIFFERENCE | ~St305 |

## FIG. 23

## FIG. 24

## INTERNATIONAL SEARCH REPORT

| International application No. |
|---|
| **PCT/JP2024/032829** |

| A. | CLASSIFICATION OF SUBJECT MATTER |
|---|---|

*H01L 21/02*(2006.01)i; *H01L 21/68*(2006.01)i; *H01L 21/683*(2006.01)i
FI:   H01L21/02 B; H01L21/68 N; H01L21/68 G

According to International Patent Classification (IPC) or to both national classification and IPC

| B. | FIELDS SEARCHED |
|---|---|

Minimum documentation searched (classification system followed by classification symbols)

H01L21/02; H01L21/68; H01L21/683

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | JP 2016-146411 A (TOKYO ELECTRON LIMITED) 12 August 2016 (2016-08-12) | 1-11 |
| A | WO 2021/070661 A1 (TOKYO ELECTRON LIMITED) 15 April 2021 (2021-04-15) | 1-11 |
| A | JP 2015-95579 A (TOKYO ELECTRON LIMITED) 18 May 2015 (2015-05-18) | 1-11 |
| A | JP 2006-287181 A (E-BEAM CORP.) 19 October 2006 (2006-10-19) | 1-11 |
| A | US 6405101 B1 (NOVELLUS SYSTEMS, INC.) 11 June 2002 (2002-06-11) | 1-11 |

☐ Further documents are listed in the continuation of Box C.    ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
|---|---|
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **07 October 2024** | **15 October 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

## INTERNATIONAL SEARCH REPORT
### Information on patent family members

International application No.

**PCT/JP2024/032829**

| Patent document cited in search report | | | Publication date (day/month/year) | Patent family member(s) | | | Publication date (day/month/year) |
|---|---|---|---|---|---|---|---|
| JP | 2016-146411 | A | 12 August 2016 | (Family: none) | | | |
| WO | 2021/070661 | A1 | 15 April 2021 | US | 2022/0415673 | A1 | |
| | | | | CN | 114556537 | A | |
| | | | | KR | 10-2022-0080134 | A | |
| JP | 2015-95579 | A | 18 May 2015 | US | 2015/0129137 | A1 | |
| | | | | KR | 10-2015-0055551 | A | |
| JP | 2006-287181 | A | 19 October 2006 | US | 2006/0169208 | A1 | |
| | | | | KR | 10-2006-0088817 | A | |
| US | 6405101 | B1 | 11 June 2002 | (Family: none) | | | |

Form PCT/ISA/210 (patent family annex) (July 2022)

**EP 4 783 225 A1**

**REFERENCES CITED IN THE DESCRIPTION**

**Patent documents cited in the description**

- JP 2015095579 A